# EUROPÄISCHE PATENTSCHRIFT

(11) **EP 3 168 708 B1**
(45) Veröffentlichungstag und Bekanntmachung des Hinweises auf die Patenterteilung: **08.08.2018**
(21) Anmeldenummer: 15193880.0
(22) Anmeldetag: 10.11.2015
(51) Int. Cl.: H01F 29/14, H02J 3/18, H03K 5/01, H03K 5/24

(54) **STUFENLOS REGELBARE SÄTTIGUNGS-KOMPENSATIONSDROSSELSPULE**
CONTINUOUSLY VARIABLE SATURATION COMPENSATION CHOKE COIL
TRANSDUCTEUR DE COMPENSATION/SATURATION REGLABLE EN CONTINU

(43) Veröffentlichungstag der Anmeldung: 17.05.2017
(73) Patentinhaber: Siemens Aktiengesellschaft, 80333 München (DE)
(72) Erfinder: Bunin, Anatoliy, 90547 Stein (DE); Loppach, Karsten, 90482 Nürnberg (DE); Schnieders, Johannes, 90469 Nürnberg (DE)

(56) Entgegenhaltungen:
- DE-A1-102012 110 969
- DE-U1-202013 004 706
- Chvanov Vjacheslav Aleksandrov ET AL: "DEVICE FOR SUPPRESSING SINGLE-PHASE ARCING GROUND FAULT CURRENT IN THREE-PHASE HIGH-VOLTAGE POWER TRANSMISSION LINE", , 20. März 2008 (2008-03-20), XP055272319, RU2320061 Gefunden im Internet: URL:http://www.freepatent.ru/images/patent s/145/2320061/patent-2320061.pdf [gefunden am 2016-05-12] & Anonymous: "Device for suppressing single-phase arcing ground fault current in three-phase high-voltage power transmission line", , 12. Mai 2016 (2016-05-12), XP055272119, Gefunden im Internet: URL:http://russianpatents.com/patent/232/2 320061.html [gefunden am 2016-05-12]

## Beschreibung

Die Erfindung betrifft eine stufenlos regelbare Sättigungs-Kompensationsdrosselspule, umfassend einen geblechten Kern mit zwei bewickelten Schenkeln je Phase, die durch Joche verbunden sind, wobei auf jedem bewickelten Schenkel ein Netzwicklungszweig angeordnet ist, und die Hochspannungsenden der beiden Netzwicklungszweige einer Phase an einen Phasenleiter und die Niederspannungsenden dieser Netzwicklungszweige an eine Gleichspannungsquelle angeschlossen sind.

Stufenlos durch die Vormagnetisierung regelbare Kompensationsdrosselspulen (MCSR: Magnetically Controlled Shunt Reactor) der eingangs genannten Art kommen zur Spannungsstabilisierung bei Lastschwankungen in Hochspannungsnetzen und - Übertragungslinien sowie zur Kompensation der überflüssigen Blindleistung in Hochspannungsnetzen und Industrieanlagen zum Einsatz.

Im Vergleich mit den durch Stufenschalter regelbaren Drosselspulen haben MCSR die folgenden Vorteile:
- ein wesentlich größerer Stellbereich der Blindleistung:
   1:100 bei einer MCSR, anstelle maximal 1:2 bei einer Drosselspule mit Regelung mittels Stufenschalter (Netze mit stark schwankender Last brauchen mindestens 1:10),
- eine wesentlich kleinere Zeit für die Änderung der Blindleistung vom Minimum zum Maximum: 0,3 s bei einer MCSR anstelle 1-3 min bei einer Drosselspule mit Regelung mittels Stufenschalter (für den Ausgleich des Netzspannungssprungs nach dem Lastabwurf sind ca. 0,3 s erforderlich),
- unbegrenzte Anzahl der Leistungseinstellungen bei einer MCSR (bei einer Drosselspule mit Regelung mittels Stufenschalter ist diese Anzahl mit der Lebensdauer der Stufenschalterkontakte begrenzt).

Zu den Nachteilen einer MCSR gegenüber einer Drosselspule mit Regelung mittels Stufenschalter gehören jedoch die Verzerrung der Stromkurve, höhere Kosten und Verluste. Im Vergleich zu statischen Blindleistungskompensatoren (SVC: Static Var Compensator), die z.B. aus Cigre-Paper 12-05, 1978, "Reactor transformer for controllable static compensators" bekannt sind, haben MCSR geringere Kosten und Verluste sowie eine höhere Zuverlässigkeit. Dies ist durch die wesentlich kleinere Leistung des elektronischen Schaltsystems verursacht (1-2% der Drosselleistung bei einer MCSR anstelle 100% bei einem SVC) .

Die erste Beschreibung des Aufbaues und der Wirkungsweise einer modernen MCSR wurde in Becker H.: "Die steuerbare Drosselspule. Ein statischer Phasenschieber zur Kompensation von Blindlaststößen." ETZ-B, 1971, Bd. 23, H. 12 vorgeschlagen. Danach besteht eine MCSR aus einem geschlossenen geblechten Eisenkern wie beim Transformator, einer Wechselstrom-Wicklung PW, die an das Einspeisungsnetz angeschlossen ist, einer Gleichstrom-Steuerwicklung GW, die von einer Gleichspannungsquelle eingespeist wird, und einer in Dreieck geschalteten Ausgleichswicklung DW. Jede der genannten Wicklungen einer Phase ist auf zwei gleiche in Reihe geschaltete Teile aufgeteilt, die auf den zwei verschiedenen Kernschenkeln gewickelt sind. Die Teile der Wicklung PW sind miteinander gleich verbunden und erzeugen in den beiden Schenkeln die gleich gerichteten Magnetflüsse AC. Die Teile der Wicklungen GW sind entgegen verbunden und erzeugen in den beiden Schenkeln die gegen gerichteten magnetischen Flüsse DC. Innerhalb einer Halbperiode addieren sich die magnetischen Flüsse AC und DC im ersten Schenkel und subtrahieren sich im zweiten Schenkel. Innerhalb der zweiten Halbperiode läuft der Vorgang umgekehrt. Bei einem ausreichend großen Vormagnetisierungsstrom in der Wicklung GW geht der Schenkel 1 in die Sättigung innerhalb eines Teils der ersten Halbperiode und der Schenkel 2 geht in die Sättigung innerhalb des gleichen Teils der zweiten Halbperiode. Während der Sättigung eines Schenkels ist die Induktivität des darauf gewickelten Teils der Wicklung PW stark reduziert, was einen Stromimpuls mit positiver oder negativer Polarität verursacht.

Durch die Variation der Gleichspannung auf der Wicklung GW kann man die Dauer des gesättigten Zustandes der Schenkel und damit die Stromamplitude in der Wicklung PW regeln. Der Verlauf des Arbeitsstroms einer MCSR ist grundsätzlich nicht sinusförmig, weil während des nicht gesättigten Zustandes eines Kernschenkels kein Strom durch die Wicklung PW fließt. Beim Nennbetrieb der MCSR beträgt die Dauer des gesättigten Zustandes jedes Schenkels genau eine halbe Periode. Dadurch wird der Strom in der Wicklung PW nahezu sinusförmig. Durch die Gegenschaltung der Wicklung GW zirkulieren in dieser Wicklung die Ströme aller geraden Harmonischen. Durch die Dreieckschaltung der Ausgleichswicklung DW zirkulieren darin die 3., 9. usw. Stromharmonischen. Somit wirken die Wicklungen GW und DW als Filter der geraden Harmonischen, sowie der durch 3 teilbaren Harmonischen. Die sonstigen Harmonischen: 5., 7., 11. usw. sind nicht kompensiert und kommen ins gespeiste Netz. Die Unterdrückung dieser Oberwellen kann bei Bedarf durch den Einsatz von äußeren an die Wicklung DW angeschlossenen LC-Filtern erreicht werden.

Im Zusammenhang mit der Entwicklung und Produktion von MCSR in Russland und der Ukraine ist in den folgenden Jahren das oben beschriebene MCSR-Design in Richtung der Verringerung der Produktionskosten und Verluste verbessert worden, siehe z.B. UdSSR-Patent No. 1762322, Patent RU 2063084, Patent RU 2132581 und Patent RU 2217829. In O. M. Budargin, L. V. Makarevitsch, L. A. Mastrukov: "Eine gesteuerte Sättigungs-Drosselspule 180 Mvar, 500 kV von OAG 'Elektrozavod'", Elektro N 6, 2012 wurde vorgeschlagen, die Vormagnetisierungswicklung GW zu entfernen und ihre Funktion auf die Netzwicklung PW zu übertragen. Gemäß dieser Veröffentlichung besteht die Netzwicklung jeder Phase aus zwei identischen Parallelzweigen, die auf den verschiedenen Kernschenkeln angeordnet sind. Die ersten Zweige aller Phasen bilden den ersten Stern und die zweiten Zweige den zweiten Stern. Die beiden Sterne sind mit den Hochspannungsenden an die Übertragungslinie AC angeschlossen. Zwischen den Sternpunkten der beiden Sterne ist eine geregelte Gleichstromquelle angeschlossen. Jeder Sternpunkt ist über eine Erdungsdrosselspule geerdet. Durch die Abschaffung der Gleichstromwicklung sind die Nennverluste um ca. 50 % und das Gesamtgewicht um ca. 15% reduziert.

Im Patent RU 2320061 wurde eine Verbesserung der genannten Lösung durch die Ersetzung einer gemeinsamen Gleichspannungsquelle durch sechs (zwei je Phase) separaten Wechselspannungsquellen D, die vom AC-Netz AC eingespeist sind. Während eines bestimmten Teils der Periode ist die Quelle D über Leistungstransistoren oder -Thyristoren mit dem Niederspannungsende des entsprechenden Netzwicklungszweigs verbunden. Dadurch wird darin ein erforderlicher Vormagnetisierungsstrom generiert. Während der Restzeit der Periode ist dieses Wicklungsende geerdet. Diese Lösung erlaubt die Erdungsdrosselspulen auszuschließen und die Ströme in den Phasen einzeln zu regeln, was ihre Symmetrie gewährleistet. Die Mitte des Vormagnetisierungsimpulses ist gegenüber der Mitte des Arbeitsstromimpulses um eine Viertelperiode verschoben, was die erforderliche Leistung der Gleichstromquelle im Vergleich mit der zuvor genannten Lösung reduziert.

Die letztgenannte Lösung wird als nächstliegender Stand der Technik angesehen. Der Hauptnachteil dieser Lösung ist das Fließen des Arbeitsstroms der MCSR während eines Teils der Periode durch die Wechselstromquelle D mit einer relativ geringeren Leistung. Mit dem Anstieg des Arbeitsstroms bis zum Nennwert wird die Dauer des Arbeitsstromimpulses immer größer, maximal eine halbe Periode, d.h. sie überschreitet die Zeitverschiebung zwischen den Impulsanfängen des Arbeits- und des Vormagnetisierungsstroms. Die Wechselstromquelle D stellt sich als Stromrichtertransformator mit einem großen Abstand zwischen den Primär- und Sekundärwicklungen dar, um die Isolationsfestigkeit dieser Strecke bei den Prüfspannungen des MCSR-Sternpunktes zu gewährleisten. Daher kann die Reaktanz zwischen den Wicklungen des Stromrichtertransformators mit der Nenninduktivität des MCSR beim voll gesättigten Kernschenkel vergleichbar sein. Dies kann zu einer Verzerrung der Stromwellenform der MCSR und zur gefährlichen Spannungserhöhung an den elektronischen Schaltern führen.

Ein weiterer Nachteil des Stands der Technik ist eine nichtlineare Abhängigkeit des Vormagnetisierungsstroms vom Steuerparameter - Dauer des Steuerimpulses an den elektronischen Schaltern - durch die nicht konstante Spannung der Quelle D innerhalb der Wirkungsdauer des Steuerimpulses. Dies führt zu einer Verringerung des Verstärkungsfaktors in der Rückkopplungsschleife im Bereich des Nennstroms der MCSR und einer entsprechenden Vergrößerung des Regelfehlers.

Es ist daher Aufgabe der Erfindung, eine stufenlos regelbare Sättigungs-Kompensationsdrosselspule der eingangs genannten Art anzugeben, welche die Leistung der Gleichspannungsquellen, den Verzerrungsgrad des Arbeitsstroms, und den Regelfehler reduziert, sowie die Anzahl der Gleichspannungsquellen vermindert.

Diese Aufgabe wird erfindungsgemäß dadurch gelöst, dass die Gleichspannungsquelle zwei stabilisierte, einpolig geerdete Stromrichter mit Gegenpolaritäten sowie je Phase zwei von einem Steuersystem gesteuerte elektronische Transistor-Umschalter umfasst, und dass das Steuersystem derart ausgebildet ist, dass die Gleichstromeinspeisung der beiden Netzwicklungszweige einer Phase impulsweise über den entsprechenden elektronischen Transistor-Umschalter erfolgt, und dass die Gleichstromeinspeisung in die beiden Netzwicklungszweige gegenpolig aus unterschiedlichen Stromrichtern erfolgt.

Die Erfindung geht dabei von der Überlegung aus, dass analog zum Stand der Technik zunächst jede Phase der MCSR zwei parallele Zweige der Netzwicklung enthält, die auf verschiedenen Schenkeln eines geblechten Kernes angeordnet und zwischen einer Netzphase und der Vormagnetisierungsquelle angeschlossen sind.

Im Unterschied zum Stand der Technik hat die hier vorgeschlagene MCSR zwei einpolig geerdete stabilisierte Stromrichter mit den positiven und negativen Polaritäten. Mittels von gesteuerten elektronischen Transistor-Umschaltern werden die entsprechenden Stromrichter kurzzeitig mit den Niederspannungsenden der parallelen Wicklungszweige verbunden. Dadurch werden in den beiden Wicklungszweigen die erforderlichen Vormagnetisierungsströme generiert.

Die Stromrichter sind dabei vorteilhafterweise gleich, d.h. identisch ausgebildet, sind dabei aber gegenpolig angeordnet.

Jedem parallelen Zweig der Netzwicklung ist ein Transistor-Umschalter zugeordnet. Die Transistor-Umschalter umfassen vorteilhafterweise jeweils zumindest drei Arbeitspositionen und eine erste Arbeitsposition verbindet das Niederspannungsende des ersten Netzwicklungszweigs mit dem ersten Stromrichter und das Niederspannungsende des zweiten Netzwicklungszweigs mit dem zweiten Stromrichter, eine zweite Arbeitsposition verbindet jedes Niederspannungsende der Netzwicklungszweige mit einem geerdeten Sternpunktanschluss, und eine dritte Arbeitsposition verbindet das Niederspannungsende des ersten Netzwicklungszweigs mit dem zweiten Stromrichter und das Niederspannungsende des zweiten Netzwicklungszweigs mit dem ersten Stromrichter, wobei die Steuerung der Arbeitspositionen der beiden Transistor-Umschalter zeitlich um eine halbe Sinusperiode versetzt abläuft.

Das Steuersystem ist dabei vorteilhafterweise dafür ausgelegt, den Arbeitsstrom der Sättigungs-Kompensationsdrosselspule durch eine Steuerung der Dauer der ersten und dritten Arbeitspositionen zu regeln. Die Amplitude des Arbeitsstroms wird dabei vorteilhafterweise mit der Sollwertamplitude verglichen. Die Abweichung steuert die Dauer der jeweiligen Arbeitspositionen in einer Phase so, dass die Abweichungen der Amplituden minimiert werden.

Weiterhin ist das Steuersystem vorteilhafterweise dafür ausgelegt, die positiven und negativen Amplituden des Arbeitsstroms jeder Phase miteinander zu vergleichen und in gleicher Weise zu steuern, um die Abweichung dazwischen zu minimieren.

Vorteilhafterweise ist während des gesättigten Zustandes eines bewickelten Kernschenkels das Niederspannungsende des darauf angeordneten Netzwicklungszweigs über den entsprechenden elektronischen Transistor-Umschalter geerdet, d.h. mit dem Sternpunktanschluss verbunden und weiter vorteilhafterweise wird während eines durch die Steuerung vorgegebenen Zeitintervalls innerhalb des nicht gesättigten Zustandes eines bewickelten Kernschenkels das Niederspannungsende des darauf angeordneten Netzwicklungszweigs über den entsprechenden elektronischen Transistor-Umschalter mit einem der Stromrichter verbunden. Die genannte Impulseinspeisung jedes Wicklungszweigs erfolgt also während der passiven Halbperioden, wenn der entsprechende Kernschenkel nicht gesättigt ist und der Arbeitsstrom im Zweig nicht fließt.

Das Steuersystem ist weiterhin vorteilhafterweise dafür ausgelegt, die Geschwindigkeit der Änderung der Amplitude des Arbeitsstroms der Sättigungs-Kompensationsdrosselspule durch eine Steuerung der Ausgangsspannungen der beiden Stromrichter zu regeln.

In weiterer vorteilhafter Ausgestaltung ist das Steuersystem dafür ausgelegt, die Amplituden des Arbeitsstroms aller Phasen miteinander zu vergleichen und die Dauer der jeweiligen Arbeitsposition in den Phasen so zu korrigieren, dass diese Amplituden gleich sind.

Die Erfindung wird anhand einer Zeichnung näher erläutert. Darin zeigen:
- FIG 1: eine vereinfachte elektrische Schaltung einer MCSR mit der mechanischen Darstellung der elektronischen Transistor-Umschalter,
- FIG 2: ein Beispiel des elektronischen Transistor-Umschalters mit IGBT-Leistungstransistoren (elektrische Darstellung des elektronischen Umschalters),
- FIG 3: den Stromverlauf in Zweigen der Netzwicklung einer Phase im Betrieb einer konstanten Last der MCSR,
- FIG 4: den Stromverlauf in Zweigen der Netzwicklung einer Phase im Betrieb eines Lastanstiegs der MCSR, und
- FIG 5: den Stromverlauf in Zweigen der Netzwicklung einer Phase im Betrieb eines Lastabwurfs der MCSR.

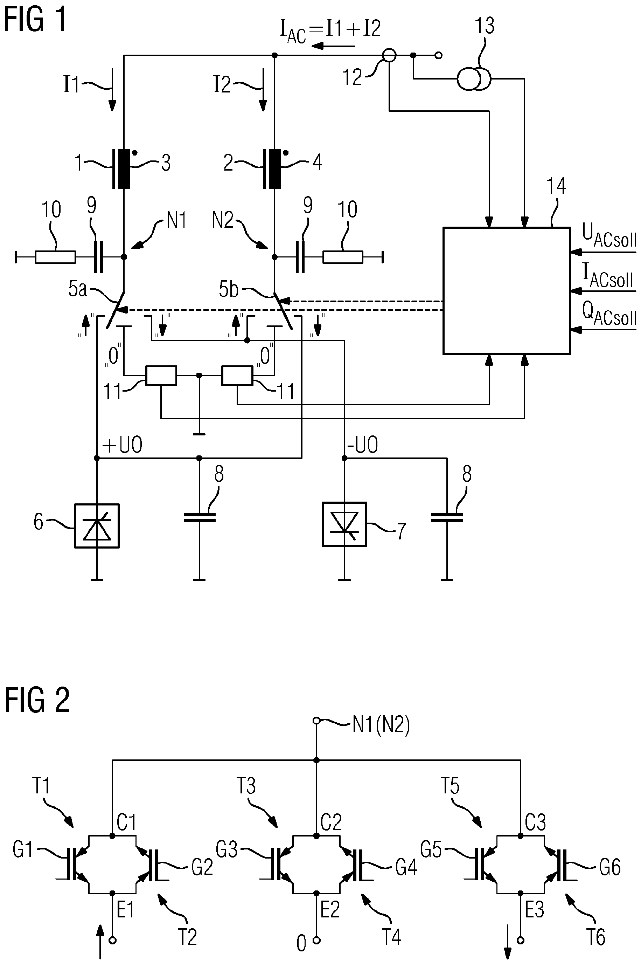

FIG 1 zeigt eine Phase einer Sättigungs-Kompensationsdrosselspule (MCSR). Jede Phase der hier beschriebenen MCSR besteht aus zwei Kernschenkeln 1, 2, auf
denen die gleichen parallelen Zweige 3, 4 der Netzwicklung gewickelt sind. Ihre Hochspannungsenden sind gemeinsam an einen Netzphasenleiter und die Niederspannungsenden N1 und N2 einzeln an die elektronischen Transistor-Umschalter 5a, 5b angeschlossen.

Die elektronischen Umschalter 5a, 5b sind unabhängig voneinander gesteuert und können eine der drei Positionen belegen: "0", "↑" und "↓". In der Position "0" ist das Wicklungsende N1 bzw. N2 mit Erde verbunden. In der Position "↑" sind das Wicklungsende N1 mit dem stabilisierten Thyristor-Stromrichter 6 mit der positiven Polarität (Spannung +U0) und das Wicklungsende N2 mit dem identischen Thyristor-Stromrichter 7 mit der negativen Polarität (Spannung -U0) verbunden. In der Stellung "↓" ist das Wicklungsende N1 mit dem negativen Stromrichter 7 und das Wicklungsende N2 mit dem positiven Stromrichter 6 verbunden.

Parallel zu den Ausgängen der Stromrichter 6, 7 sind die Glättungskondensatoren 8 mit einer großen Kapazität angeschlossen. Die Enden N1, N2 der Zweige 3, 4 der Netzwicklung sind mit Erde über die RC-Glieder (bestehend aus Kapazität 9 und Widerstand 10) verbunden. Diese RC-Glieder 9, 10 dienen zur Begrenzung der Potentiale der Punkte N1 und N2 während einer kurzen galvanischen Stromunterbrechung in den Zweigen 3, 4 der Netzwicklung bei den Übergängen der elektronischen Umschalter 5a, 5b von einer Position zu einer anderen Position. Die Widerstände 10 begrenzen dabei die Umladungsströme der Kondensatoren 8, 9 im Anfangszeitpunkt nach der Umschaltung der elektronischen Umschalter 5a, 5b, um die Stromüberlast der Transistoren zu vermeiden.

Die Steuerung der elektronischen Umschalter 5a, 5b erfolgt durch ein Steuersystem 14, das die Ist-Signale vom MCSR-Stromsensor 12 und vom Netzspannungssensor 13 mit den vorgegebenen Sollwerten IACsoll und UACsoll vergleicht. Je nach dem Wert und Vorzeichen der Differenz-Abweichungssignale generiert das Steuersystem 14 die Steuersignale für die elektronischen Umschalter 5a, 5b, die die Dauer und die Polarität der Impulse der DC-Einspeisung bestimmen.

Die Hallsensoren 11 dienen zum Vergleich der positiven und negativen Amplituden des Arbeitsstroms der MCSR. Wenn diese Amplituden infolge ungleicher magnetischer Zustände der Kernschenkel 1, 2 einer Phase nicht gleich sind, korrigiert das Steuersystem 14 die Vormagnetisierungsströme in den Zweigen 3, 4 der Netzwicklung, um eine vollständigere Unterdrückung der Gleichkomponente und der geraden Harmonischen im Arbeitsstrom der MCSR zu erreichen. Zur Unterdrückung der durch drei teilbaren Harmonischen können auf jedem Kernschenkel 1, 2 zusätzliche in Dreieck geschaltete Ausgleichswicklungen angeordnet werden (in FIG 1 nicht gezeigt).

FIG 2 zeigt eine detailliertere Darstellung der elektronischen Umschalter 5a, 5b. Jeder elektronische Umschalter 5a, 5b besteht aus drei identischen Transistorschaltern nach der Anzahl der Betriebspositionen des Umschalters. Jeder Transistorschalter ist durch die Parallelschaltung zweier entgegen geschalteter Leistungstransistoren T1, T2 (bzw. T3, T4; T5, T6), zum Bespiel IGBT-Transistoren, gebildet. Beim Anlegen einer entsperrenden Spannung an die Steuerelektroden G1, G2 (bzw. G3, G4; G5, G6) befinden sich die beiden Transistoren T1 bzw. T2 im leitenden Zustand und führen den Strom in beide Richtungen durch.

Während einer Umschaltung sperren sich zuerst die Transistoren T1, T2 eines bisher leitenden Schalters und erst in einer kurzen Zeit von ca. 0,1 ms danach entsperren sich die Transistoren eines bisher gesperrten Schalters. Zur Entkopplung des Steuersystems 14 von den Leistungstransistoren T1, T2 und somit vom MCSR-Sternpunkt werden die Steuersignale an die Elektroden G1, G2 über ein Lichtleitkabel geleitet.

Im Folgenden wird die Wirkungsweise der bis hier beschriebenen elektrischen Schaltung der MCSR beschrieben.
Bei der Einschaltung der Netzwicklungen 3, 4 ans AC-Netz (AC: Alternating Current, Wechselstrom) treten in den Kernschenkeln 1, 2 die gleich gerichteten AC-Magnetflüsse auf. Wenn dabei in den Wicklungszweigen 3, 4 kein Vormagnetisierungsstrom fließt, ist der Kern nicht gesättigt und verbraucht in der MCSR nur einen geringen Leerlaufstrom, wie ein Transformator.

Beim gleichzeitigen Auftreten in den Wicklungszweigen 3, 4 der Gleichströme mit den entgegengesetzten Polaritäten treten in den Kernschenkeln 1, 2 die entgegen gerichteten DC-Magnetflüsse (DC: Direct Current, Gleichstrom) auf, die mit den AC-Flüssen zusammenaddiert sind. Dadurch wechseln sich in jedem Kernschenkel 1, 2 die aktiven Halbperioden, wenn die Richtungen der AC- und DC-Ströme gleich sind, mit den passiven Halbperioden, wenn diese Ströme entgegengesetzt gerichtet sind, ab. Während einer aktiven Halbperiode kann der Kernschenkel innerhalb eines bestimmten Teils der Halbperiode gesättigt werden. Die abwechselnde Sättigung der Schenkel 1, 2 ruft im Wicklungszweig 3 positive und im Wicklungszweig 4 negative netzfrequente Stromimpulse hervor, die im Phasenleiter zu einem bipolaren Stromverlauf führen. Mit zunehmendem Vormagnetisierungsstrom erhöhen sich die Dauer und die Amplitude dieser Impulse.

Im Nennbetrieb sind die Kernschenkel 1, 2 während der ganzen aktiven Halbperiode gesättigt. Während einer aktiven Halbperiode belegt der Umschalter 5a (5b) die Position "0", was einen Durchfluss des Arbeitsstroms durch die Stromrichter 6, 7 verhindert und ihre Leistung reduziert. Während einer passiven Halbperiode ist der entsprechende Kernschenkel 1 bzw. 2 nicht gesättigt und durch den darauf gewickelten Netzwicklungszweig 3 bzw.4 fließt nur ein relativ kleiner Vormagnetisierungsstrom. Erst innerhalb dieses Zeitintervalls kann das Wicklungsende N1, N2 mit einem Stromrichter 6, 7 verbunden werden.

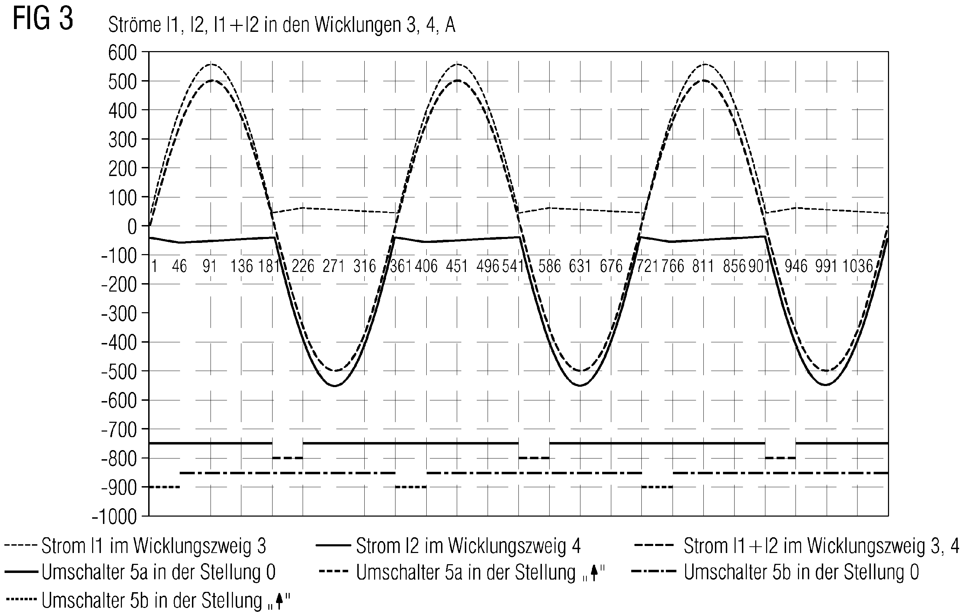

Die Funktionsweise wird anhand der Graphen in FIG 3 bis FIG 5 näher erläutert. Diese zeigen jeweils den zeitlichen Verlauf der Ströme I1, I2 durch die Netzwicklungszweige 3 bzw. 4 und deren Summe I1+I2=IAC, jeweils in Ampere. Im unteren Bereich der FIG 3 bis FIG 5 sind die zur jeweiligen Zeit vorherrschenden Stellungen der Umschalter 5a, 5b gezeigt.

Im Betrieb mit einer konstanten Last der MCSR (FIG 3) muss der Vormagnetisierungsstrom konstant sein. Durch eine große Zeitkonstante der Zweige 3 bzw. 4 der Netzwicklung im Vergleich mit der AC-Periode ist eine Reduzierung dieses Stroms innerhalb der Periode, die durch die Verluste in der Netzwicklung und in den Umschaltern 5a, 5b verursacht wird, gering. Die Wiederherstellung des Vormagnetisierungsstroms auf den Ausgangswert erfolgt innerhalb eines kurzen Zeitintervalls der passiven Halbperiode, wenn der elektronische Umschalter 5a bzw. 5b in der Position "↑" steht. Innerhalb dieses Zeitintervalls steigt der Vormagnetisierungsstrom linear mit einer Geschwindigkeit, die der Spannung U0 der DC-Quellen 6, 7 proportional ist.

Die Dauer dieses Zeitintervalls bestimmt das Steuersystem 14 in Abhängigkeit von der Regelabweichung in der vorhergehenden AC-Periode. Wenn diese Regelabweichung innerhalb einer akzeptablen Grenze liegt, bleibt der elektronische Umschalter 5a, 5b während der ganzen Periode in der Position "0".

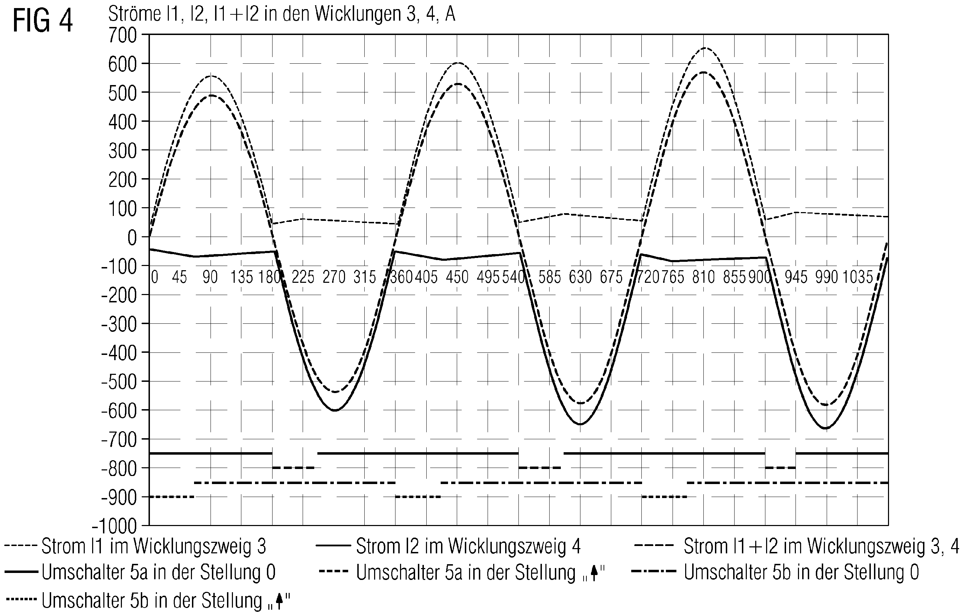

Im Betrieb eines Lastanstiegs der MCSR (FIG 4) muss der Vormagnetisierungsstrom von Periode zu Periode erhöht werden, bis er einen neuen Wert erreicht, der für einen erhöhten Wert des Arbeitsstroms erforderlich ist. Dieser Betrieb unterscheidet sich vom Betrieb mit konstantem Strom nur mit einem längeren Zeitintervall, bei dem die elektronischen Umschalter 5a, 5b in der Position "↑" stehen. Das Steuersystem 14 begrenzt die Dauer dieses Zeitintervalls auf die Dauer des nicht gesättigten Zustandes der Kernschenkel, um einen Durchfluss des Arbeitsstroms durch die Stromrichter 6, 7 auszuschließen. Nach der Erreichung des neuen Wertes des geregelten Parameters (Amplitude der MCSR-Stroms oder der Netzspannung) versetzt das Steuersystem 14 die elektronischen Umschalter 5a, 5b in den Betrieb der konstanten Last. Um die Dauer des Übergangsvorganges zu reduzieren, erhöht das Steuersystem bei einer großen Regelabweichung automatisch die Spannungen ±U0 der Thyristor-Stromrichter 6, 7.

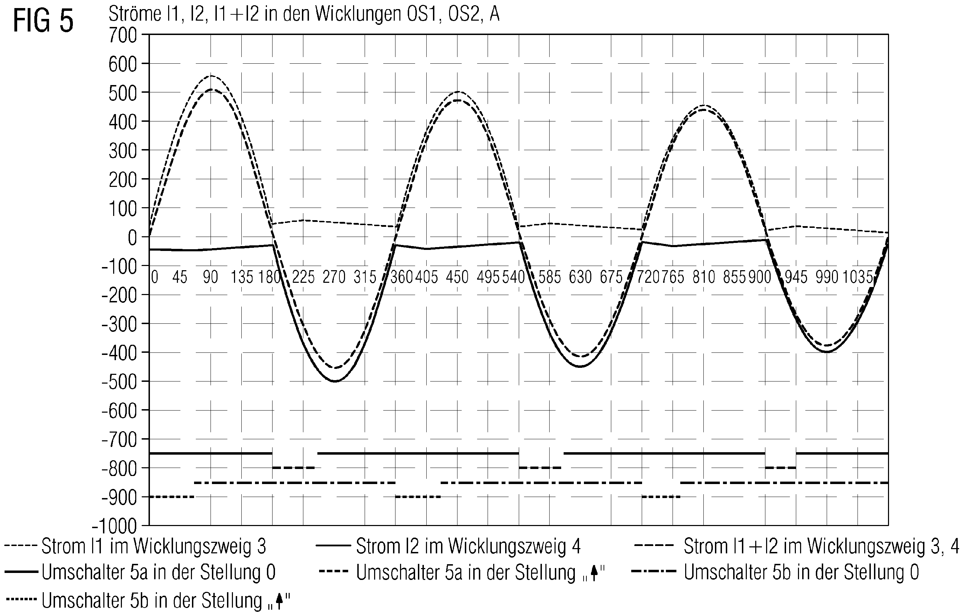

Im Betrieb eines Lastabwurfs der MCSR (FIG 5) muss der Vormagnetisierungsstrom von Periode zu Periode reduziert werden, bis er einen neuen Wert erreicht, der für einen reduzierten Wert des Arbeitsstroms erforderlich ist. In diesem Betrieb versetzt das Steuersystem 14 während der passiven Halbeperioden die elektronischen Umschalter 5a, 5b in die Position "↓". Die Dauer dieses Zustands der elektronischen Umschalter ist dem Wert der Regelabweichung proportional. Wie im Betrieb eines Lastanstiegs ist die Dauer des Zustandes "↓" der elektronischen Umschalter auf die Dauer des nicht gesättigten Zustandes der Kernschenkel begrenzt. In diesem Betrieb funktionieren die Stromrichter 6, 7 als Inverter. Dadurch kehrt der Gleichanteil der Energie des MCSR-Magnetfeldes ins Einspeisungsnetz zurück. Wie im Betrieb eines Lastanstiegs erhöht das Steuersystem 14 bei einer großen Regelabweichung automatisch die Spannungen ± U0 der Thyristor-Stromrichter 6, 7.

### Bezugszeichenliste

- 1, 2: Kernschenkel
- 3, 4: Netzwicklungszweig
- 5a, 5b: Transistor-Umschalter
- 6, 7: Thyristor-Stromrichter
- 8: Glättungskondensator
- 9: Kondensator
- 10: Widerstand
- 11: Hallsensor
- 12: MCSR-Stromsensor
- 13: Netzspannungssensor
- 14: Steuersystem

- C1, C2, C3: Kollektor
- E1, E2, E3: Emitter
- G1, G2, G3 G4, G5, G6: Steuerelektrode
- I1, I2, IAC: Strom
- IACsoll: Strom-Sollwert
- QACsoll: Blindleistungs-Sollwert
- N1, N2: Niederspannungsende
- T1, T2, T3 T4, T5, T6: Leistungstransistor
- U0: Spannung
- UACsoll: Spannungs-Sollwert

## Patentansprüche

1. Stufenlos regelbare Sättigungs-Kompensationsdrosselspule, umfassend einen geblechten Kern mit zwei bewickelten Schenkeln (1, 2) je Phase, die durch Joche verbunden sind, wobei auf jedem bewickelten Schenkel (1, 2) ein Netzwicklungszweig (3, 4) angeordnet ist, und die Hochspannungsenden der beiden Netzwicklungszweige (3, 4) einer Phase an einen Phasenleiter und die Niederspannungsenden (N1, N2)dieser Netzwicklungszweige an eine Gleichspannungsquelle angeschlossen sind,
**dadurch gekennzeichnet, dass**
die Gleichspannungsquelle zwei stabilisierte, einpolig geerdete Stromrichter (6, 7) mit Gegenpolaritäten sowie je Phase zwei von einem Steuersystem (14) gesteuerte elektronische Transistor-Umschalter (5a, 5b) umfasst, und dass das Steuersystem (14) derart ausgebildet ist, dass die Gleichstromeinspeisung der beiden Netzwicklungszweige (3, 4) einer Phase impulsweise über den entsprechenden elektronischen Transistor-Umschalter (5a, 5b) erfolgt, und dass die Gleichstromeinspeisung in die beiden Netzwicklungszweige (3, 4) gegenpolig aus unterschiedlichen Stromrichtern (6, 7) erfolgt.

2. Stufenlos regelbare Sättigungs-Kompensationsdrosselspule nach Anspruch 1, wobei die Stromrichter (6, 7) gleich ausgebildet sind.

3. Stufenlos regelbare Sättigungs-Kompensationsdrosselspule nach Anspruch 1 oder 2, wobei die Transistor-Umschalter (5a, 5b) jeweils zumindest drei Arbeitspositionen umfassen und eine erste Arbeitsposition das Niederspannungsende (N1) des ersten Netzwicklungszweigs (3) mit dem ersten Stromrichter (6) und das Niederspannungsende (N2) des zweiten Netzwicklungszweigs (4) mit dem zweiten Stromrichter (7) verbindet, eine zweite Arbeitsposition jedes Niederspannungsende (N1, N2) der Netzwicklungszweige (3, 4) mit einem geerdeten Sternpunktanschluss verbindet, und eine dritte Arbeitsposition das Niederspannungsende (N1) des ersten Netzwicklungszweigs (3) mit dem zweiten Stromrichter (7) und das Niederspannungsende (N2) des zweiten Netzwicklungszweigs (4) mit dem ersten Stromrichter (6) verbindet, wobei die Steuerung der Arbeitspositionen der beiden Transistor-Umschalter (5a, 5b) zeitlich um eine halbe Sinusperiode versetzt abläuft.

4. Stufenlos regelbare Sättigungs-Kompensationsdrosselspule nach Anspruch 3, wobei das Steuersystem (14) dafür ausgelegt ist, den Arbeitsstrom der Sättigungs-Kompensationsdrosselspule durch eine Steuerung der Dauer der ersten und dritten Arbeitspositionen zu regeln.

5. Stufenlos regelbare Sättigungs-Kompensationsdrosselspule nach Anspruch 4, wobei das Steuersystem (14) dafür ausgelegt ist, die Ist- und Sollwertamplituden, sowie die positiven und negativen Amplituden des Arbeitsstroms jeder Phase jeweils miteinander zu vergleichen und die Dauer der jeweiligen Arbeitspositionen in einer Phase so zu korrigieren, dass die Abweichungen der Amplituden minimiert werden.

6. Stufenlos regelbare Sättigungs-Kompensationsdrosselspule nach einem der vorhergehenden Ansprüche, wobei während des gesättigten Zustandes eines bewickelten Kernschenkels (1, 2) das Niederspannungsende (N1, N2) des darauf angeordneten Netzwicklungszweigs (3, 4) über den entsprechenden elektronischen Transistor-Umschalter (5a, 5b) geerdet ist.

7. Stufenlos regelbare Sättigungs-Kompensationsdrosselspule nach einem der vorhergehenden Ansprüche, wobei während eines vorgegebenen Zeitintervalls innerhalb des nicht gesättigten Zustandes eines bewickelten Kernschenkels (1, 2) das Niederspannungsende (N1,N2) des darauf angeordneten Netzwicklungszweigs (3, 4) über den entsprechenden elektronischen Transistor-Umschalter (5a, 5b) mit einem der Stromrichter (6, 7) verbunden wird.

8. Stufenlos regelbare Sättigungs-Kompensationsdrosselspule nach einem der vorhergehenden Ansprüche, wobei das Steuersystem (14) dafür ausgelegt ist, die Geschwindigkeit der Änderung des Arbeitsstroms der Sättigungs-Kompensationsdrosselspule durch eine Steuerung der Ausgangsspannungen der beiden Stromrichter (6, 7) automatisch zu regeln.

9. Stufenlos regelbare Sättigungs-Kompensationsdrosselspule nach einem der vorhergehenden Ansprüche, wobei das Steuersystem (14) dafür ausgelegt ist, die Amplituden des Arbeitsstroms aller Phasen miteinander zu vergleichen und die Dauer der jeweiligen Arbeitsposition in den Phasen so zu korrigieren, dass diese Amplituden gleich sind.

## Claims

1. Continuously variable saturable shunt reactor, comprising a laminated core having two wound limbs (1, 2) for each phase, which limbs are connected by yokes, wherein a network winding branch (3, 4) is arranged on each wound limb (1, 2), and the high-voltage ends of the two network winding branches (3, 4) of a phase are connected to a phase conductor and the low-voltage ends (N1, N2) of these network winding branches are connected to a DC voltage source,
**characterized in that**
the DC voltage source comprises two stabilized, single-pole-grounded power converters (6, 7) with opposite polarities and also two electronic transistor changeover switches (5a, 5b), which are controlled by a control system (14), for each phase, and **in that** the control system (14) is designed in such a way that direct current is fed to the two network winding branches (3, 4) of a phase in pulses by means of the corresponding electronic transistor changeover switch (5a, 5b), and that the direct current is fed into the two network winding branches (3, 4) at opposite poles from different power converters (6, 7).

2. Continuously variable saturable shunt reactor according to Claim 1, wherein the power converters (6, 7) are of identical design.

3. Continuously variable saturable shunt reactor according to Claim 1 or 2, wherein the transistor changeover switches (5a, 5b) each comprise at least three operating positions, and a first operating position connects the low-voltage end (N1) of the first network winding branch (3) to the first power converter (6) and the low-voltage end (N2) of the second network winding branch (4) to the second power converter (7), a second operating position connects each low-voltage end (N1, N2) of the network winding branches (3, 4) to a grounded star point connection, and a third operating position connects the low-voltage end (N1) of the first network winding branch (3) to the second power converter (7) and the low-voltage end (N2) of the second network winding branch (4) to the first power converter (6), wherein control of the operating positions of the two transistor changeover switches (5a, 5b) takes place with a temporal offset of half a sine period.

4. Continuously variable saturable shunt reactor according to Claim 3, wherein the control system (14) is designed to control the operating current of the saturable shunt reactor by controlling the duration of the first and third operating positions.

5. Continuously variable saturable shunt reactor according to Claim 4, wherein the control system (14) is designed to compare the actual and setpoint value amplitudes, and also the positive and negative amplitudes of the operating current of each phase with one another in each case, and to correct the duration of the respective operating positions in a phase such that the deviations of the amplitudes are minimized.

6. Continuously variable saturable shunt reactor according to one of the preceding claims, wherein, during the saturated state of a wound core limb (1, 2), the low-voltage end (N1, N2) of the network winding branch (3, 4) which is arranged on it is grounded by means of the corresponding electronic transistor changeover switch (5a, 5b).

7. Continuously variable saturable shunt reactor according to one of the preceding claims, wherein, during a prespecified time interval within the unsaturated state of a wound core limb (1, 2), the low-voltage end (N1, N2) of the network winding branch (3, 4) which is arranged on it is connected to one of the power converters (6, 7) by means of the corresponding electronic transistor changeover switch (5a, 5b).

8. Continuously variable saturable shunt reactor according to one of the preceding claims, wherein the control system (14) is designed to automatically control the rate of change in the operating current of the saturable shunt reactor by controlling the output voltages of the two power converters (6, 7).

9. Continuously variable saturable shunt reactor according to one of the preceding claims, wherein the control system (14) is designed to compare the amplitudes of the operating current of all of the phases with one another, and to correct the duration of the respective operating position in the phases such that these amplitudes are the same.

## Revendications

1. Bobine de self de compensation-saturation réglable en continu, comprenant un noyau feuilleté ayant deux branches (1, 2) bobinées par phase, qui sont reliées par des culasses, dans laquelle sur chaque branche (1, 2) bobinée est disposée une branche (3, 4) d'enroulement de réseau et les extrémités de haute tension des deux branches (3, 4) d'enroulement de réseau d'une phase sont raccordées à un conducteur de phase et les extrémités (N1, N2) de basse tension de ces branches d'enroulement de réseau sont raccordées à une source de tension continue,
**caractérisée en ce que**
la source de tension continue comprend deux redresseurs (6, 7) stabilisés mis à la terre par un pôle et à polarités antagonistes ainsi que, par phase, deux commutateurs (5a, 5b) à transistor électroniques commandés par un système (14) de commande, et **en ce que** le système (14) de commande est constitué de manière à ce que l'injection de courant continu des deux branches (3, 4) de bobinage de réseau d'une phase s'effectue par impulsion par le commutateur (5a, 5b) à transistor électronique correspondant et **en ce que** l'injection de courant continu dans les deux branches (3, 4) d'enroulement de réseau s'effectue en opposition à partir de redresseurs (6, 7) différents.

2. Bobine de self à compensation de saturation réglable en continu suivant la revendication 1, dans laquelle les redresseurs (6, 7) sont constitués pareillement.

3. Bobine de self à compensation de saturation réglable en continu suivant la revendication 1 ou 2, dans laquelle les commutateurs (5a, 5b) à transistor comprennent chacun au moins trois positions de travail et une première position de travail relie l'extrémité (N1) de basse tension de la première branche (3) d'enroulement de réseau au premier redresseur (6) et l'extrémité (N2) de basse tension de la deuxième branche (4) d'enroulement de réseau au deuxième redresseur (7), une deuxième position de travail relie chaque extrémité (N1, N2) de basse tension des branches (3, 4) d'enroulement de réseau à une borne de point étoile mise à la terre et une troisième position de travail relie l'extrémité (N1) de basse tension de la première branche (3) d'enroulement de réseau au deuxième redresseur (7) et l'extrémité (N2) de basse tension de la deuxième branche (4) d'enroulement de réseau au premier redresseur (6), la commande des positions de travail des deux commutateurs (5a, 5b) à transistor se déroulant de manière décalée dans le temps d'une demi période sinusoïdale.

4. Bobine de self à compensation de saturation réglable en continu suivant la revendication 3, dans laquelle le système (14) de commande est conçu pour réguler le courant de travail de la bobine de self à compensation de saturation par une commande de la durée des première et troisième positions de travail.

5. Bobine de self à compensation de saturation réglable en continu suivant la revendication 4, dans laquelle le système (14) de commande est conçu pour comparer entre elles les amplitudes de valeur réelle et de valeur de consigne ainsi que les amplitudes positives et négatives du courant de travail de chaque phase et à corriger la durée des positions de travail dans une phase, de manière à minimiser les écarts des amplitudes.

6. Bobine de self à compensation de saturation réglable en continu suivant l'une des revendications précédentes, dans laquelle, pendant l'état saturé d'une branche (1, 2) de noyau bobinée, l'extrémité (N1, N2) de basse tension de la branche (3, 4) d'enroulement de réseau, qui y est disposée, est mise à la terre par le commutateur (5a, 5b) à transistor électronique correspondant.

7. Bobine de self à compensation de saturation réglable en continu suivant l'une des revendications précédentes, dans laquelle, pendant un intervalle de temps donné à l'avance dans l'état non saturé d'une branche (1, 2) de noyau bobinée, l'extrémité (N1, N2) de basse tension de la branche (3, 4) d'enroulement de réseau, qui y est montée, est reliée à l'un des redresseurs (6, 7) par le commutateur (5a, 5b) à transistor électronique correspondant.

8. Bobine de self à compensation de saturation réglable en continu suivant l'une des revendications précédentes, dans laquelle le système (14) de commande est conçu pour réguler automatiquement la vitesse de la variation du courant de travail de la bobine de self à compensation de saturation par une commande des tensions de sortie des deux redresseurs (6, 7).

9. Bobine de self à compensation de saturation réglable en continu suivant l'une des revendications précédentes, dans laquelle le système (14) de commande est conçu pour comparer entre elles les amplitudes du courant de travail de toutes les phases et pour corriger la durée de la position de travail respective dans les phases, de manière à ce que ces amplitudes soient égales.
